# EUROPEAN PATENT SPECIFICATION

(11) **EP 3 540 762 B1**
(45) Date of publication and mention of the grant of the patent: **14.10.2020**
(21) Application number: 19162325.5
(22) Date of filing: 12.03.2019
(51) Int. Cl.: H01L 21/3063, H01L 31/18, C25F 3/12

(54) **METHOD FOR THE FABRICATION OF A POROUS SEMICONDUCTOR WITH CONTROLLED PORES DISTRIBUTION**
VERFAHREN ZUR HERSTELLUNG EINES PORÖSEN HALBLEITERS MIT KONTROLLIERTER PORENVERTEILUNG
PROCÉDÉ DE FABRICATION D'UN SEMICONDUCTEUR POREUX AVEC RÉGULATION DE LA DISTRIBUTION DE PORES

(30) Priority: 12.03.2018 IT 201800003427
(43) Date of publication of application: 18.09.2019
(73) Proprietor: Università Degli Studi di Cagliari, 09124 Cagliari (IT)
(72) Inventor: Mula, Guido, 09124 Cagliari (IT); Pinna, Elisa, 09124 Cagliari (IT); Mehrabanian, Mehran, 09124 Cagliari (IT); Riva, Eugenio Redolfi, 09124 Cagliari (IT); Cara, Eleonora, 09124 Cagliari (IT)
(74) Representative: Montevecchi, Emma

(56) References cited:
- WO-A1-03/077298
- US-B2- 6 964 732

## Description

### Technical field

The present invention relates to a method for the production of a porous semiconductor, and in particular to a method to produce controlled indentations on a surface of a semiconductor where a third layer is formed, and wherein the third layer has an optimal control of its pores distribution.

### Technological Background

Porous materials, such as porous silicon, have been known since the '50. Despite this early discovery, the scientific community was not interested in porous silicon until the late 1980s. Theoretical and experimental results showed that the porous silicon displays quantum confinement effects. In particular, it was revealed that silicon wafers can emit light if subjected to electrochemical and chemical dissolution.

The published results stimulated the interest of the scientific community in these non-linear optical and electrical properties. The growing interest was evidenced in the number of published works concerning the properties and potential applications of porous silicon.

The application of porous silicon and the interest on the material is thus growing and wide spread. Porous silicon is found in a variety of applications where its benign nature, electronic and optical properties and entrapment of other materials are desirable.

During recent years, semiconducting silicon crystals have proved to be a useful material to build photocells for electricity generation, despite very restrictive requirements in terms of purity of the silicon precursors and high-temperature fabrication. Porous silicon, which is a nanostructured material with outstanding optical and semiconducting properties, is very attractive for solar cell applications, given its band gap broadening, wide absorption spectrum and good antireflection properties for optical coatings. Due to its luminescence properties, it has been considered as a suitable candidate for light emitting devices, as well as for sensing ones. It can also be used for photoelectrochemical splitting of water in order to convert solar energy into electrochemical energy while producing hydrogen, and has other numerous application areas including biosensors, photosensitizers, batteries, and tissue engineering.

Porous silicon is often obtained by electrochemical anodization. This method consists in anodic dissolution of highly purified doped silicon wafers in aqueous or alcoholic media and generally involves the use of hydrofluoric acid as an etching agent. For example, and as described in WO1997/006101, bulk crystalline silicon can be rendered porous by partial electrochemical dissolution in hydrofluoric acid (HF)-based solutions. This etching process generates a silicon structure that retains the crystallinity and the crystallographic orientation of the original bulk material. Hence, the porous silicon formed is a form of crystalline silicon. Broadly, the method involves anodising, for example, a doped silicon wafer in an electrochemical cell which contains an electrolyte comprising a solution of hydrofluoric acid in an alcohol. Following the passing of an anodization current, a porous silicon layer is produced which may be separated from the wafer by increasing the current density for a short period of time. The effect of this is to dissolve the silicon at the interface between the porous and bulk crystalline regions.

US 6964732 discloses a method and apparatus for slicing a semiconductor substrate. In one embodiment, the invention allows repetitive etching of a surface of the semiconductor substrate with a time dependent concentration of F- and a time dependent current I, such that multiple porous layers are obtained. The porous layer is removed and the released porous layer from the surface of the substrate. The surface roughness of the porous layer is maintained within an acceptable or desired level of roughness value. The invention also provides an apparatus including a container having an etching solution. The semiconductor substrate may be protected by a tube covering at least a potion of said semiconductor substrate from said etching solution. The rate of insertion of said semiconductor substrate into the container is controlled to synchronize the lift-off with the insertion of the correct thickness of the semiconductor substrate. The anodising current is provided between two electrodes during operation.

In order to control the size of the pores and their distribution, several studies have been performed. For example, the effect of the HF content of the electrochemical etching solution and of the applied current was investigated to improve the pore size distribution in Granitzer, P. & Rumpf, K. Porous Silicon - A Versatile Host Material. Materials (Basel) 3, 943-998 (2010) and in Rumpf, K., Granitzer, P., Koshida, N., Poelt, P. & Michor, H. Morphology Controlled Magnetic Interactions in Metal Embedded Porous Silicon Nanostructures. ECS J. Solid State Sci. Technol. 4, N41-N43 (2015). In these studies, the dependence of the size distribution from the training parameters such as current and HF concentration was observed.

In Ogata, Y. H., Koyama, A., Harraz, F. A., Salem, M. S. & Sakka, T. Electrochemical formation of porous silicon with medium-sized pores. Electrochemistry 75, 270 (2007), the possibility of controlling the pore size on highly doped PSi samples by adding an oxidant to the electrochemical etching solution has been studied. However, the question about the possibility of obtaining a large-scale nanolithography to control pore size and their distribution using nanolithography remains unanswered.

As a general rule, the size and distribution of the pores strongly depend on the type and quantity of doping and on the electrochemical parameters (e.g. concentration of HF, presence of oxidants and / or surfactants, current density, illumination). However, as described above, surface lithography also plays a fundamental role in the properties of pores. However, the use of lithography becomes increasingly complex when the distribution and the size of the "natural" pores are at the nanoscale, where standard optical lithography becomes impossible in consideration of the inevitable diffraction limits.

Porous silicon may also be made using the so-called stain-etching technique which is another conventional method for making porous silicon. This method involves the immersion of a silicon sample in a hydrofluoric acid solution containing a strong oxidising agent. No electrical contact is made with the silicon, and no potential is applied. The hydrofluoric acid etches the surface of the silicon to create pores. Up until now stain etching has tended to have poor reproducibility, low yield, be strongly exothermic and produce internal surface areas which are significantly lower than those obtained from anodising wafers.

Further, another technique to form a porous pattern on silicon is electron beam lithography. While electron beam lithography is clearly an obvious method for nanoscale patterning, this method takes too much time to be scalable for large surface applications.

There is a continued need for alternative and preferably improved methods for making porous semiconductors, such as silicon, which address at least some of the issues mentioned above.

### Summary of the invention

The object of the invention is to solve the problem of pores' formation control, in particular at the nanoscale, i.e. for those pores' dimensions for which optical lithography cannot be used, thus for their formation it may be necessary to go towards more sophisticated techniques such as Electron Beam Lithography or Focussed Ion Beam. These techniques achieve a very high spatial precision but involve machines with a high purchase and maintenance costs and require very long time for surface structuring. They are therefore suitable for use on very small surfaces (at most a few tens of µm²).

The proposed invention instead, called in the following electrochemical nanolithography, ENL, proposes to use a relatively low-cost electrochemical process that also allows an application on much larger surfaces (for example wafers, like Si wafers, of 4 inches in diameter or larger). In other words, the present invention uses the standard anodization process for the preparation of a surface of the substrate where the porous region is going to be formed, as detailed below.

The starting point is that for the control of the formation of the pores on a surface of a semiconductor substrate it is important to check the superficial morphology of the surface of the same substrate where the pores are going to be formed. Indeed, the pores are most likely to be formed where special "seeds", or indentations of the surface, are present. In the present invention, these seeds are realized using an electrochemical lithographic technique so that the locations of the seeds and/or their density can be controlled, and a further porous surface can be obtained with pores at the seeds' location.

The electrochemical formation of the pores begins on the surface of the semiconductor substrate at the points where the electric field is maximum, which corresponds to the irregularities of the surface. For a planar surface, at any level, there are also slight variations in surface roughness, small imperfections even at the atomic level, which act as primers for the formation of pores. For a homogeneous surface, these initial attachment points are randomly distributed on the surface.

The proposed invention is therefore aimed at the realization of "surface defects" (indentations) in controlled positions which allows the electrochemical attack to start only in those predefined surface positions, so that a layer (third layer) having a properly distributed pattern with the desired pores' density is obtained on a surface of the semiconductor substrate.

According to an aspect, the invention relates to a method for the fabrication of a porous layer with controlled pores distribution in a semiconductor substrate having a free surface by anodic etching, including the steps of:
- selecting a desired density of pores;
- selecting:
   ∘ a relative concentration of one or more components of a first etching solution, said components comprising an acid and possibly a surfactant and/or an oxidizing agent, and/or
   ∘ a parameter of a first current, and/or
   ∘ an intensity of an electromagnetic radiation impinging on a free surface of the semiconductor substrate
   on the basis of said desired density of pores;
- contacting the free surface of the semiconductor substrate with the first chemical etching solution, and, during the contact, applying the first current so as to form a first porous layer having substantially the desired density of pores;
- changing:
   ∘ the parameter of the first current, obtaining a second current, and/or
   ∘ the relative concentration of one or more components of the first etching solution, obtaining a second etching solution,
   ∘ and/or the intensity of the electromagnetic radiation impinging on the free surface of the semiconductor substrate,
   so as to continue to etch the semiconductor surface and form a second porous layer underneath the first layer, in such a way that the second porous layer has pores having a mean pore dimension larger than a mean pore dimension of the pores of the first porous layer;
- selecting a region of the semiconductor where the first and second porous layer are present;
- in that selected region removing:
   ∘ the first layer completely, and
   ∘ the second porous layer partially, to obtain a new free surface of the semiconductor substrate on which indentations are formed having a controlled distribution;
- etching the new free surface to form a third porous layer having a pores distribution function of the distribution of the indentations.

The proposed process realizes the desired pattern of seeds, called indentations, for the formation of a porous layer (the third layer) by the manufacture of a porous double layer on a surface of a semiconductor substrate: the first layer is used to control the density of the pores, the second layer to regulate their surface distribution.

The electrochemical pore formation process depends on the distribution of the charges in the substrate, the current used for the electrochemical dissolution process and the electrochemical solution composition (that is, the components in the etching solution). The electrochemical pore formation may also depend on an intensity of an electromagnetic radiation impinging on the semiconductor substrate. The wavelength of the electromagnetic radiation should be the same as the absorbing wavelength of the substrate. It is therefore very difficult, on a single layer, to control the process beyond the limits imposed by the electrochemical balance imposed by the properties of the system according to the parameters just mentioned.

Since the density of the pores and their distribution are controllable but are linked to each other for a given set of parameters, in the present invention the two processes, in order to independently control the two parameters, are separated. The first layer therefore serves to control the density of the pores and the second layer to control their distribution. Alternatively, the combination of first and second layer may modify the electrochemical conditions to obtain a third porous layer having a given density, i.e. a subsequent third porous layer is not constrained to a given set of parameters of the etching step in order to obtain a given density of pores, as detailed below.

As a starting material, a semiconductor substrate is considered. Various types of substrates may be exposed to the etching process. For instance, in some embodiments, the substrates include, without limitation, semiconductor wafers, n-type semiconductor substrates, p-type semiconductor substrates, polished semiconductor substrates, and combinations thereof.

The substrate may include crystalline semiconductor or semi-crystalline semiconductor. Preferably the substrate is crystalline silicon.

The substrates of the present disclosure can have various resistivities. For instance, in some embodiments, the substrates of the present disclosure can have resistivities that range from about 0.0001 ohm-cm (Ω·cm) to about 25 ohm-cm (Ω·cm). In some embodiments, the porous silicon substrates of the present disclosure can have resistivities that range from about 0.0001 ohm-cm (Ω·cm) to about 20 ohm-cm (Ω·cm). In some embodiments, the silicon substrates of the present disclosure can have resistivities that range from about 0.0001 ohm-cm (Ω·cm) to about 10 ohm-cm (Ω·cm). In some embodiments, the porous silicon substrates of the present disclosure can have resistivities that range from about 0.0001 ohm-cm (Ω·cm) to about 20 ohm-cm (Ω·cm).

Various numbers of substrates may be simultaneously exposed to the etching process.

The substrate includes a surface, that is, a free surface, which is desired to render porous. All the free surface can be rendered porous according to the method of the invention or only a part of it. Preferably, the free surface is substantially planar, however other types of geometry can be considered as well.

According to the invention, the density of pores is selected. That is, the number of pores per unit area which is desired to obtain in the "end" porous layer is selected (i.e. the number of pores to be obtained in the third porous layer to be fabricated after the surface of the semiconductor has been treated by forming the first and second layers and then removing the same).

On the selected free surface, a first layer of porous semiconductor is formed using a "standard" electrochemical anodization process by means of a first etching solution and the application of a first current.

The parameters of this first etching process are so selected that the first porous layer obtained on the free surface (or portion thereof) has the desired density of pores, regardless of their distribution. Therefore, the various parameters of the first etching process are selected, as known in the art, to obtain a given pores density.

The first etching solution includes an acid.

Possible acids include, but are not limited to, the following.

The acid may be selected from the group consisting of nitric, phosphoric, sulfuric, and HX-type acids.

In another particular embodiment of the invention, the acid is a mineral HX-type acid. By "mineral HX-type acid", it is understood a mineral acid containing at least one halogen atom.

The term "halogen" as used in the present invention refers to an atom of fluorine (F), chlorine (CI), bromine (Br) or iodine (I), preferably F or Cl.

When used in the present application, the widespread notation "X" intends to refer to a halogen atom, as well-understood by the one skilled in the art.

The term "mineral HX-type acid" hence includes, but is not limited to, HF, HCI, HBr, HI, HBF4, HPF6, HAsF₆, HSbF₆, HFSO₃ SbF₅, HSO₃CF₃, HFSOs, HClO₄ and HB(CN)(CF₃)₃.

Further, but not necessarily, the first etching solution may also include an oxidizing agent and/or a surfactant.

As oxidizing agents, the preferred ones are H₂O₂ and nitric acid.

As surfactants, alcohols, NCW-1001 (Wako Pure Chemical Ind.), sodium lauryl sulfate, may be used. The exposure of the semiconductor substrates to the first etching solution including an acid and possibly but not necessarily and oxidizing agent and a surfactant in the presence of a current results in the etching of the surface (or of a portion thereof) of the semiconductor substrate and the formation of a first porous layer from the semiconductor substrate. Without being bound by theory, it is envisioned that etching can occur by various mechanisms.

For instance, in some embodiments, etching occurs by electrochemical etching. In some embodiments, etching occurs when ions from the acid etch the substrate surface as a current is passed through the semiconductor substrate in an acid solution.

The exposure of the substrate to first etching solution and first current can occur in various environments and under various conditions. For instance, in some embodiments, the exposure of substrates to acid in the presence of a current occurs simultaneously. In some embodiments, the exposure of the substrates to acid in the presence of a current occurs under ambient conditions, such as room temperature and atmospheric pressure.

The etching process can for example take place in an electrochemical cell where two electrodes are present for the application of the current to the substrate. In an embodiment, the semiconductor substrate is an electrode of the cell.

The semiconductor substrates of the present disclosure can be exposed to various types of first currents. For instance, in some embodiments, the substrate can be exposed to a constant current as a first current. In some embodiments, the substrate can be exposed to a variant current. In some embodiments, the substrates can be exposed to a gradually increasing or gradually decreasing current.

The substrates may be exposed to a first current having a first current density comprised between about 0.1 mA/cm² to about 10 A/cm².

The semiconductor substrate can be exposed to a first current for various periods of time. The substrates are exposed to a first current for a time sufficient to etch the surface or a portion thereof to a desired depth. In some embodiments, the silicon substrates of the present disclosure are exposed to a first current for a time interval comprised between from about fractions of seconds to several hours.

In some embodiments, the exposure time of the semiconductor substrate to the first current is correlated to the strength of the applied current. For instance, in some embodiments, shorter times are used for higher currents while longer times are used for weaker currents.

In some embodiments, the ions etch the side of a substrate facing a negative electrode while the other side of the substrate remains unetched.

The etching of the first porous layer stops when a desired thickness of the first layer is desired, called first thickness. The depth of etching may be directly related to the strength of the first current and the exposure time. For instance, in some embodiments where substrates (e.g., silicon wafers) are between 100 microns to 600 microns thick, the etch depths (first thickness) range from 0.1 microns to 30 microns.

The parameters selected for the realization of the first porous layer depends on the desired density of pores on the surface. This desired density is the density of pores in a (third) porous layer to be realized on the substrate at the end of the double-layer formation (detailed below) and their removal, i.e. after the surface of the semiconductor substrate has been prepared with a plurality of indentation obtained forming two porous layers one underneath the other and then removing them. This density is substantially the same density of pores of the first layer, however the distribution of the pores is different, as detailed below.

In order to obtain the desired density of pores, the parameters of the first etching process such as the relative concentrations of the components of the first etching solution or parameters of the first current, are selected on the basis of the desired density of pores to be achieved on the first porous layer. These parameters have to be selected also on the basis of the doping concentration of the substrate. Regarding the first etching solution, the concentration of components means the concentration of: the acid and/or of the surfactant (if present) and/or of the oxidizing agent (if present). Another parameter might include the intensity of an electromagnetic radiation impinging on the surface to be treated of the semiconductor substrate. The wavelength of the electromagnetic radiation is the one at which the substrate material shows absorption.

The formation of the first layer defines the density of the pores of the further third porous layer to be built after the surface treatment of the invention.

When the desired first thickness of the first layer is reached, then one or more parameters of the etching process are changed. A parameter of the first current can be changed, so that a second current is obtained, and/or the relative concentration of one of the components of the first etching solution can be changed, so that a second etching solution is obtained. Alternatively or in addition, an electromagnetic radiation may be introduced to impinge on the surface. If an electromagnetic radiation was already present during the formation of the first porous layer, the intensity of the same radiation may be modified. The parameters of the etching process are selected so that bigger pores are preferably obtained in a further etching step where a second porous layer is obtained.

In other words, after the formation of the first porous layer, the etching continues changing the parameters of the etching process so that the second etching gives rise to pores in a second porous layer having a bigger dimension than the pores already formed in the first porous layer.

In order to obtain wider pores, a parameter of the first current, or the concentration of the acid in the first etching solution, or the intensity of the impinging electromagnetic radiation can be modified. Alternatively, an oxidizing agent or a surfactant can be added to the first etching solution. The oxidizing agent and/or surfactant could have been present also in the first etching solution used to etch the first layer, thus in order to widen the pores their relative concentrations can be modified in the second etching solution. A multiple modification of parameters of the first current, concentration of one or more components of the first etching solution so as to create a second etching solution and/or second current and impinging electromagnetic radiation can be performed as well.

Preferred methods to form wider pores in the second layer are an increase of the applied current and/or a decrease of the acid concentration and/or the addition of an oxidizing agent.

With the term "bigger pores" it is meant that - on average - the dimension of the pores in a direction lying on a plane defined by the free surface of the semiconductor substrate is on average bigger in the second layer than in the first one. This direction may be perpendicular to the etching direction. This dimension can be also called "diameter" in case the pores are substantially circular.

Dimension of the pores means in the present description the size of the pores at the surface, that is, the dimension of the pores in a direction parallel to the surface of the semiconductor substrate. It can also be considered the "diameter" of the pores if they have a substantially cylindrical shape. The parameters which need to be adjusted in the second etching step in order to obtain a second porous layer underneath the first one are described with reference to the first layer (same conditions and ranges apply).

The second etching solution includes an acid.

Possible acids include, but are not limited to, the following.

The acid may be selected from the group consisting of nitric, phosphoric, sulfuric, and HX-type acids. In another particular embodiment of the invention, the acid is a mineral HX-type acid. By "mineral HX-type acid", it is understood a mineral acid containing at least one halogen atom.

The term "halogen" as used in the present invention refers to an atom of fluorine (F), chlorine (CI), bromine (Br) or iodine (I), preferably F or Cl.

When used in the present application, the widespread notation "X" intends to refer to a halogen atom, as well-understood by the one skilled in the art.

The term "mineral HX-type acid" hence includes, but is not limited to, HF, HCl, HBr, HI, HBF4, HPF6, HAsF₆, HSbF₆, HFSO₃ SbF₅, HSO₃CF₃, HFSO₃, HClO₄ and HB(CN)(CF₃)₃. Further, but not necessarily, the second etching solution may also include an oxidizing agent and/or a surfactant.

As oxidizing agents, the preferred ones are H₂O₂ and nitric acid.

As surfactants, alcohols, NCW-1001 (Wako Pure Chemical Ind.), sodium lauryl sulfate, may be used. The exposure of the semiconductor substrates to the first etching solution including an acid and possibly but not necessarily and oxidizing agent and a surfactant in the presence of a current results in the etching of the surface (or of a portion thereof) of the semiconductor substrate and the formation of a first porous layer from the semiconductor substrate. Without being bound by theory, it is envisioned that etching can occur by various mechanisms.

For instance, in some embodiments, etching occurs by electrochemical etching. In some embodiments, etching occurs when ions from the acid etch the substrate surface as a current is passed through the semiconductor substrate in an acid solution.

The exposure of the substrate to second etching solution and second current can occur in various environments and under various conditions. For instance, in some embodiments, the exposure of substrates to acid in the presence of a current occurs simultaneously. In some embodiments, the exposure of the substrates to acid in the presence of a current occurs under ambient conditions, such as room temperature and atmospheric pressure.

The etching process can for example take place in an electrochemical cell where two electrodes are present for the application of the current to the substrate. In an embodiment, the semiconductor substrate is an electrode of the cell.

The semiconductor substrates of the present disclosure can be exposed to various types of second currents. For instance, in some embodiments, the substrate can be exposed to a constant current as a second current. In some embodiments, the substrate can be exposed to a variant current. In some embodiments, the substrates can be exposed to a gradually increasing or gradually decreasing current.

The substrates may be exposed to a second current having a second current density comprised between about 0.1 mA/cm² to about 10 A/cm².

The semiconductor substrate can be exposed to a second current for various periods of time. The substrates are exposed to a second current for a time sufficient to etch the surface or a portion thereof to a desired depth. In some embodiments, the silicon substrates of the present disclosure are exposed to a second current for a time interval comprised between from about fractions of seconds to several hours.

In some embodiments, the exposure time of the semiconductor substrate to the second current is correlated to the strength of the applied current. For instance, in some embodiments, shorter times are used for higher currents while longer times are used for weaker currents.

In some embodiments, the ions etch the side of a substrate facing a negative electrode while the other side of the substrate remains unetched. A stack of a first porous layer followed by a second porous layer is formed by etching on the substrate.

In the above, the direction of etching is preferably substantially perpendicular to the surface of the semiconductor substrate. Preferably the pores are thus "vertical". However, in particular in case of a crystalline substrate, the etching may follow the crystal's planes and therefore tilted pores with respect to the surface of the substrate may be formed.

With the appropriate conditions of the etching step, the pores in the second porous layer have low dendriticity and are distributed in a homogeneous pattern thanks to the redistribution of the electric field in the process. The process of self-ordering depends on the fact that the electric field tends to distribute homogeneously. Thanks to the electrochemical etching conditions which are preferably selected so that in the second layer "large" and substantially all equal pores are formed, the redistribution of the electric field result in a regular distribution of the pores in the second layer regardless of the order or disorder of the pores present in the first layer.

It is important to underline that the second layer, given that it is etched after the first layer but without removing the latter, can only result as having a formation of pores with a density constrained to the number of pores present in the first layer. Thus, there is a strong correlation between the number of pores in the first layer and the number of pores in the second layer. In fact, the etching solution (first or second) during the etching of the second layer is present only in the pores already formed in the first layer and does not have contact with the other parts of the substrate. Thus, the pores formed with a given density in the first layer will grow deeper into the second layer due to the etching. The pores formed in the first layer simply widen due to the new etching parameters and better distribute so as to form a substantially uniform distribution. The redistribution is due to the fact that the size of the pores changes and the electric field tends to homogenize its distribution.

With the term "more uniform distribution of pores", the following is meant. Due to the widening of the pores, a lower dispersion in the size of the pores is achieved (that is, the pores have all a more similar diameter among each other) and further they form a more orderly pattern, their spatial distribution resembles an orderly lattice.

Therefore, the number of pores in the second porous layer, and thus the density of pores in the second porous layer, is correlated to that of the first layer. The number of pores is not exactly identical because, in their widening, two pores may merge, but it is very similar and can be considered very tightly correlated. However, the centre of the "same pore" starting in the first layer and continuing in the second layer "shifts" because the pores in the second layer change their mutual distance.

In other words, the pores in the first layer create the constraint that forces the second layer to have substantially the same pore number or a very much correlated number of pores to those of the first layer.

The etching of the second layer terminates when a second thickness is reached.

Preferably, the first thickness of the first porous layer is comprised between 100 nm and 30 µm.

Preferably, the second thickness of the second porous layer is comprised between 100 nm and 30 µm.

Further, preferably the average pores dimension (where with "dimension" of the pores their dimension in a direction parallel to the etched surface is meant, which then therefore for a cylindrical pore it is equivalent to its diameter) is as follows:
from 15 nm to 200 nm in the second porous layer,
from 10 nm to 150 nm in the first porous layer.

After the formation of these two layers, the first and second layers are removed at least in part. This means that the first porous layer, at least in a portion thereof, is removed for all its thickness, while the second porous layer is removed preferably up to a given depth. The chemical removal of the first and second porous layer preferably allows leaving on the surface of the substrate only the bottom portion of the pores of the second layer. These "bottom portions" may be used as the starting "seeds" for the formation of pores in a third porous layer according to the experimenter's wishes in terms of density and distribution. These "bottom portions" of the pores formed in the second layer form indentations on a newly formed free surface of the semiconductor when the first layer and part of the second layer are removed. These indentations are the starting point for pores in a third layer. The dimension of the future pores in a third layer is necessarily bound to the next electrochemical process (that is, it depends on the parameters chosen for the electrochemical etching, both in terms of current and etching solution), however now the surface of the substrate has a plurality of seeds which are distributed in an orderly and essentially all identical way.

It is to be understood that when it is mentioned that the first layer is removed, it is meant that in a given region of the substrate, the whole thickness of the first layer is removed. There might be other regions of the sample where the first layer is not removed (for example, it is desired to create the third layer only in a portion of the sample). The same applies to the removal of the second layer: the second layer is removed for a thickness smaller than the second thickness, so that the remaining part of the second layers includes the ends of the pores, which define indentations on a new free surface of the substrate. This removal of the first and second layer may take place only in a limited area of the semiconductor (i.e. selected region) and the rest may remain untouched.

In order to remove the first and the second porous layer, alkaline etchants may be used, for example potassium hydroxide (KOH) and tetramethyl ammonium hydroxide (TMAH). Other inorganic and organic compounds such as lithium hydroxide (LiOH), sodium hydroxide (NaOH), rubidium hydroxide (RbOH), caesium hydroxide (CsOH), ammonium hydroxide (NH₄OH), cholin and ethylenediamine can been used as well. The etching rate of the semiconductor in these etchants is highly dependent on the crystal planes, the doping level of the semiconductor, the etchant concentration and its temperature.

With the surface treatment of the invention, therefore, the substrate is left with a "new" free surface which still includes a "very small portion" of the second porous layer. This "small portion" is substantially the amount of material necessary to define indentations which act as seeds for a third etching of the new free substrate. These seeds (which correspond to the negative of the end portion of the pores in the second layer) have a density which has been defined by the first layer and a spatial distribution which has been defined by the second layer.

Therefore, when the new free surface having indentation is etched again, the distribution of pores which can be fabricated in the third layer is defined by the indentation and thus it has a well-defined distribution, because its density and spatial distribution have been determined by the first and second layer.

This determination does not mean that the distribution of the pores in the third layer is "identical" to the distribution of indentations in the newly formed surface, it means that there is a "strong correlation" between the two.

The pores that are formed in the third layer are "fixed" in distribution but still have variable characteristics that depends on the etching process, such as their dimensions, their depth, etc. These further characteristics may depend for example from the third etching process' characteristics. The invention achieves therefore the goal of obtaining a controlled pores distribution in a third layer by an electrochemical process in three steps. The first two steps are etching steps which involve the formation of two porous layers one after the other, in order to be able to control in the first the pores' density (in the first layer) and in the second their surface distribution (second layer). The third step consists in the dissolution of this double layer in order to leave indentations on the surface that, similarly to what happens with the other lithographic processes, provides the starting points for the subsequent formation of pores in a third layer. The pores in the third layer can then be formed with a density and distribution controlled by the two dissolved layers and not by the process used for their formation.

Alternatively or in addition, the double layer formation and removal is done not to obtain a spatially uniform configuration, but to render the density of the pores to be formed in the third layer etched in the newly formed surface of the semiconductor substrate less bound to electrochemical parameters to obtain the desired density. In other words, generally to obtain a given density of pores in a layer, certain parameters of the etching process need to be set. However, if the first and second layer are realized, and then removed with the exception of the lower-most portion of the second layer as detailed above, the etching used for the subsequent formation of a third porous layer is not constrained to those parameters to obtain the given density because the density of pores has been substantially fixed by the number of seeds present on the new free surface of the substrate. Thus, the formation of the third layer can be tailored for the pores density by the double layer and for the pores' shape and dimension with the electrochemical parameters chosen by the experimenter for the third layer.

The invention according to the above mentioned aspect may include, in addition or alternatively, one or more of the following aspects.

Preferably, said semiconductor substrate is a silicon substrate and said first and/or second and/or said third porous layers are a first, second and/or third porous silicon layers.

Silicon is the most studied semiconductor and porous silicon has been studied for a relatively long time. Applications of porous silicon technology are already on the market. Preferably the substrate is crystalline, more preferably it comprises crystalline silicon.

Preferably, said semiconductor substrate is either p-doped or n-doped.

The parameters to be selected in the etching of the first and/or second and/or third porous layer in order to obtain the desired density of pores or the desired size of pores depend also on the type of dopant and on its concentration.

Preferably, the etching of the third layer includes:
- contacting the new free surface of the semiconductor substrate with a third chemical etching solution, and, during the contact, applying a third current so as to form the third porous layer.

The third chemical solution and the third current may also be coincident with those used for the fabrication of the first or of the second layer. The choice of these parameters in the third etching will depend only on the experimenter preferred pores dimensions for a given application, since the pores distribution has been defined by the surface indentations leaved by the etching of the first two layers. As an example, it is possible to fabricate thin pores (e.g. 10-30 nm diameter) using high HF concentrations (e.g. 20-35%) and low third currents (tens of mA/cm²) to fabricate thin pores and then use a NaOH-based solution to enlarge the pores after the formation process, so that the dendritic structure will be reduced, and the pores diameter increased. Another possibility would be to fabricate larger pores (e.g. 30-60 nm diameter) using lower concentrations of HF (e.g. 5-20%) and higher third current densities (e.g. hundreds of mA/cm²) to fabricate pores having a more regular shape in their length. A pores enlargement process, made after the pores formation process, will enable the possibility to control the thickness of the walls separating one pore from its closest-neighbour pores and, therefore, control the inter-pores interactions of a material that may possibly be inserted inside the pores (e.g. magnetic materials, metals, luminescent materials, polymers, ...)

The removal of the first and second layer leaves a plurality of seeds on a new surface of the substrate because the end part of the second layer is left. These seeds can be used as the location of the pores in the fabrication of a third layer. The etching in a third electrochemical process is going to start at the seeds' location, so that a third porous layer etched in the semiconductor substrate has a pattern of pores defined by the location of seeds. The size of these pores is determined by the parameters of the electrochemical process, such as current parameters and relative concentrations of components of the third etching solution. Illumination by an electromagnetic radiation can be used as well.

Preferably, said acid in the first etching solution and/or in the second etching solution and/or in said third etching solution is one of: Hydrofluoric acid, hydrochloric acid, nitric acid.

Preferably, the first etching solution and/or the second etching solution and/or the third etching includes one or more: water, hydrofluoric acid, a surfactant, an oxidizing agent.

Preferably, the first and the second layer have a first and a second thickness, respectively, and the step of removing the first porous layer completely and second porous layer partially includes removing a portion of the first layer through all its first thickness and removing a portion of the second layer for a depth smaller than the second thickness. More preferably, the third layer is formed starting from the part of the second layer which has remained after the first and second porous layers complete and partial removal. The thickness of the remaining part of the second layer is at least ½ of the dimension (preferably average dimension) of the mean size of the pores of the second porous layer. For substantially cylindrical pores, preferably the remaining part of the second layer has a thickness at least equal to the mean radius of the pores of the second porous layer. More preferably, the third layer is formed starting from the bottom of the seeds left in the new free surface after the etching of the first and second layers.

The removal, preferably by a chemical etchant, of the first and second layer is preferably performed till a depth smaller than the combined first and second thickness, so that on the new free surface of the substrate a plurality of seeds or indentation are left. The complete removal of the first layer and the partial removal of the second layer are preferably performed in a single etching step. These indentations have a density defined by the pores of the first layer and a geometrical distribution defined by the pores of the second layer. They thus define the pattern of seeding points acting as starting points for the formation of pores in a third layer fabricated etching again the substrate in a third electrochemical etching process to form a third porous layer.

Preferably, the formation of the first and/or second and/or third porous layer takes place in an electrochemical cell.

Preferably, the first, second and third etching process are "standard" electrochemical etching process and can be performed in an electrochemical cell.

Preferably, the step of removing the first porous layer completely and the second porous layer partially includes etching the first and second porous layer.

### Brief description of the drawings

The invention will be now described in detail with reference to the appended drawings, where:
- Figures 1a - 1c are a schematic representation of various steps of the method of the invention;
- Figures 2a-2b are a schematic representation of the steps of the figures 1a-1c in further details;
- Figures 3a-3c show three SEM pictures in a side view of three different samples where a third layer has been fabricated after the removal of a first and second layer according to the invention. The second and third layer have been fabricated using the same experimental conditions in all samples, while the current density changes in the fabrication of the first layer from one sample to the others;
- Figures 4a-4c are top views corresponding to the lateral views 3a-3c;
- Figure 5 is a schematic drawing of a cell where the etching process takes place;
- Figures 6a-6c are SEM pictures top views of a surface of a substrate after the removal of a single porous layer for different etching time during the removal;
- Figures 7a-7c are SEM pictures which are the lateral views (cross section) of Figures 6a-6c;
- Figure 8a is a SEM picture top view of an embodiment of a third layer realized according to the invention;
- Figures 8b and 9a and 9b (where 9b is an enlarged view of an insert of 10a) are method steps for an analysis of the pores distribution in Figure 8a using FFT;
- Figure 10a is a SEM picture top view of a further embodiment of a third layer realized according to the invention;
- Figures 10b and 11a and 11b (where 11b is an enlarged view of an insert of 12a) are method steps for an analysis of the pores distribution in Figure 10a using FFT;
- Figure 12a is a SEM picture top view of a further embodiment of a third layer realized according to the invention;
- Figures 12b and 13a and 13b (where 13b is an enlarged view of an insert of 13a) are method steps for an analysis of the pores distribution in Figure 12a using FFT;
- Figure 14 is the result of FFT analysis according to the methods of figs. 8b and 9a-b, 10b and 11a-b, 12b and 13a-b; and

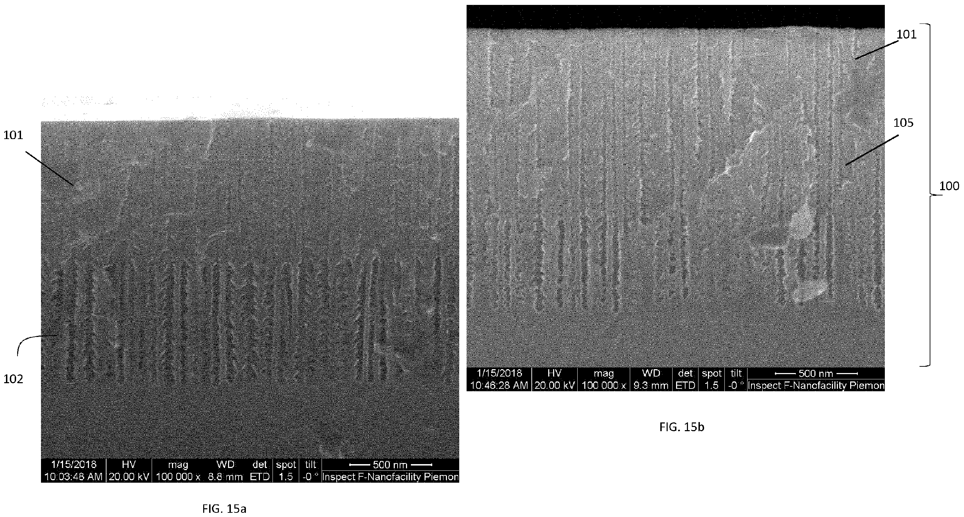

- Figure 15a-b are SEMS pictures in cross section of two structure where a double layer on a substrate is realized according to the invention.

### Detailed description of preferred embodiments

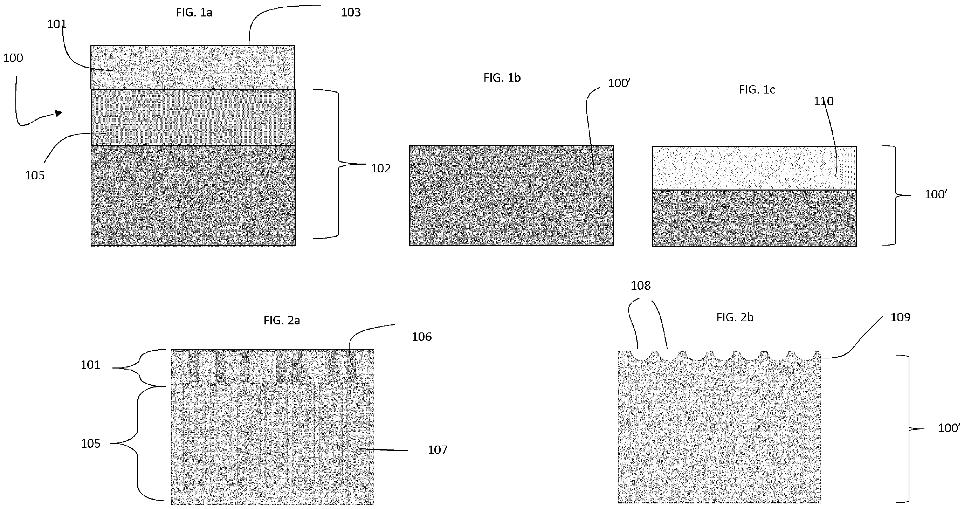

With initial reference to FIGS. 1a-1c, various phases of a production process for preparing a surface of a semiconductor substrate, denoted in the figures with the reference 100, for a subsequent realization of a porous layer, according to an embodiment of the invention are shown.

As shown in FIG. 1a, the production process starts with a semiconductor substrate 100 (for example, consisting of a wafer of mono-crystalline silicon) having a free surface 103.

The treatment of such free surface 103 includes the formation of two porous layers and their removal at least in part to obtain a new surface where a third porous layer is formed.

The treatment of the invention be applied on the full wafer, or the same or different porous layers may be repeated in several identical areas of the wafer that are then diced at the end of the process. That is, the treatment may involve the whole free surface 103 or just part of the same.

A first porous silicon layer 101 is formed in the semiconductor substrate 100; the first porous layer 101 extends preferably from the front (upper) surface 103 of the silicon 100, so as to leave a remaining portion thereof of non-porous, or compact, substrate (denoted with the reference 102). Other surfaces in addition or alternatively to the front one 103 may be subject of the above-mentioned process.

For this purpose, the silicon substrate 100 is subjected to an anodic process (acting on its front surface 103). Particularly, the silicon substrate 100 is used as an anode in an electrochemical cell (including an electrolyte). Depending on multiple experimental factors, the electrochemical etching starts where the holes reach the irregularities of the front surface of the substrate 100 that increase the local electric field activating then the corrosion process in correspondence of these holes and/or irregularities.

The characteristics of the first porous layer 101 depend on its morphology, which in turn is a function of a regime of the anodic process being defined by different parameters (for example, the duration of the etching process, the concentration and the type of impurities of the substrate 100, the current density, the type of electrolyte, and the like).

In particular, during the anodic process to form the first layer 101, the substrate 100 is subject to a first current and to a first etching solution. The first etching solution includes an acid and possibly (but not necessarily) a surfactant and an oxidizing agent. The concentrations of the components of the first etching solution and of the first current are selected so that a desired density of pores (=number of pores per unit area) is achieved in the first porous layer 101.

The anodic process of the first porous layer terminates when the first layer reaches a first thickness T1.

The parameters of the anodic process are then changed. In particular either parameter of the first current or relative concentrations of the first etching solution (i.e. the concentration of the acid and/or the surfactant and/or the oxidizing agent) or both are modified in order to form a second porous layer 105 underneath the first porous layer 101.

The second porous layer is formed in an analogue way as the first one, just with different parameters of the anodic process. The parameters are so selected to obtain wider pores than those in the first layer 101.

Preferred methods to form wider pores in the second layer 105 are an increase of the applied current and/or a decrease of the acid concentration and/or the addition of an oxidizing agent.

The anodic process of the first porous layer terminates when the second layer reaches a first thickness T2.

In figure 2a, which is a detailed view of figure 1a, the pores in the first and in the second layers 101, 105 are shown. The anodic process continues from the pores 106 present in the first layer 101 into the pores 107 present in the second layer. Therefore, the number of pores 106 in the first layer is substantially the same as or strongly correlated to the number of pores 107 in the second layer 105.

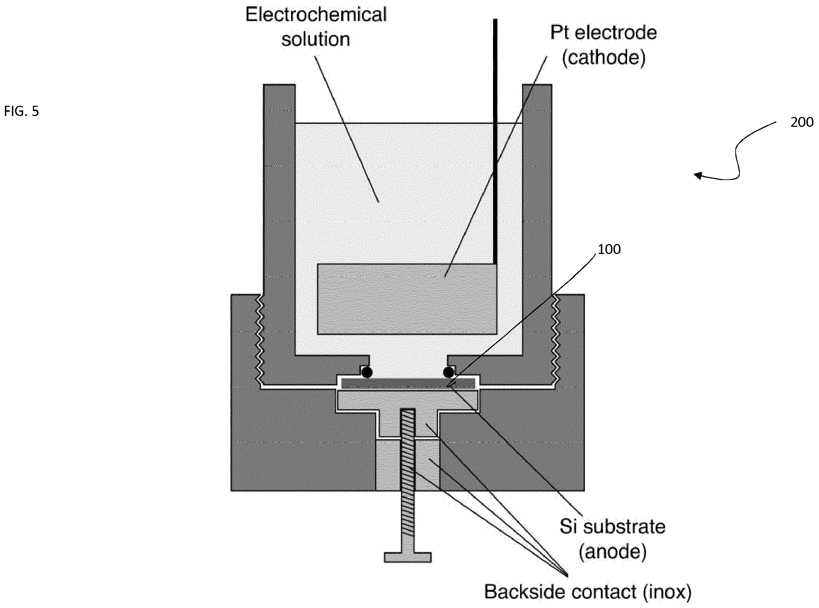

In a further step of the method of the invention, the first and second layer are removed, however not completely. A "small" end portion 109 of the second layer 105 remains on the substrate 100' (the substrate 100' is substrate 100 in which the first and second layer have been removed). The end portion 109 includes the end part 108 of the pores 107 formed in the second porous layer 105 (see figure 2b which is a more detailed view of figure 1b). These end parts 108 form seeds for the formation of a third layer 110. In other words, if after the removal of the first and second layer, with the exception of the latter end portion 109, a third porous layer 110 is realized of the end portion 109, the pores of the third layer will start from the end parts 108 of the pores which have not been removed (the end part of the pores meaning the part of the substrate surrounding the cavity forming the end of the pores). A third layer 110 then, which is realized according to given experimental condition, may be grown on the end portion 109 and the positions of its pores is the position of the end parts 108 of the pores of the second porous layer. The dimension of the pores of the third layer is selected according to what is desired. This phase is depicted in figure 1c. All the etching steps described above are realized in a cell 200 as depicted in figure 5. All electrochemical processes were performed using a PARSTAT 2273 potentiostat by Princeton Applied Research (Oak Ridge, TN, USA) or a Keithley 2450 SourceMeter SMU. The electrochemical cell 200 used for all experiments is shown in Figure 5 where the different parts are indicated. The optical reflectivity measurements were performed using a PerkinElmer Lambda 950 UV-VIS-NIR spectrometer (PerkinElmer, Waltham, MA, USA). SEM images were obtained using a FEI (Thermo Fisher Scientific) Inspec F microscope equipped with a FEG gun. The accelerating voltage used in each image is indicated in the lower part of the images.

In the Examples below, the density of pores is calculated from a cross section of the substrate.

### Example 1

The semiconductor substrate 100 in all the following examples is bulk Si wafer from Sil'tronix, (100) oriented, Phosphorous doping, conductivity in the 15-18 mOhm/cm range.

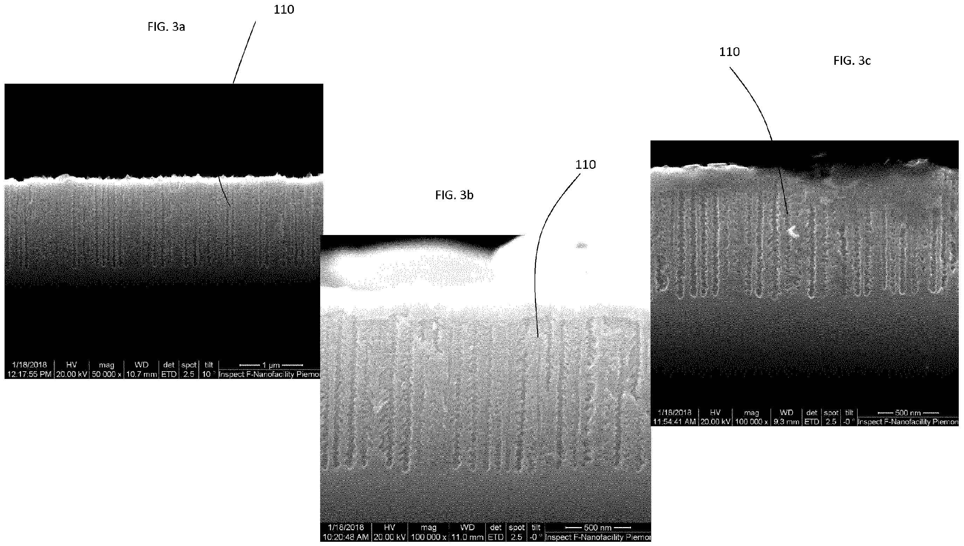

In figures 3a - 3c the realization of the first layer 101 under different anodic conditions is shown. Three different densities of pores can be achieved in a third layer 110 changing only the density of pores in the first layer 101. In other words, the first layer has different densities in the three examples, the second layer is fabricated always in the same way, and this results in a third layer having different densities.

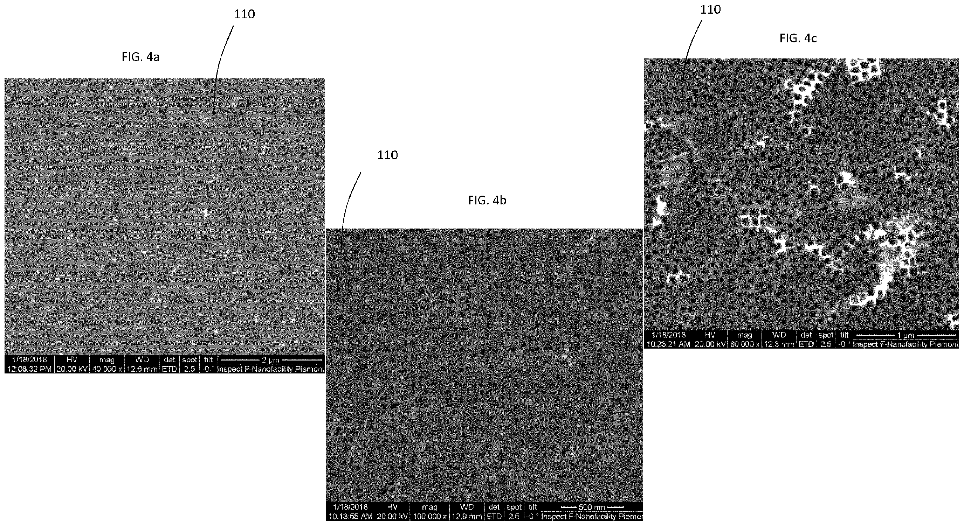

### Sample 1 of figures 3a and 4a

The first layer is realized using:
First etching Solution: HF 25%, H₂O 25%, EtOH 50%
Current: 600 mA/cm²
Etching time:1s
room temperature (P)
Princeton Applied Research potentiostat model PARSTAT 2270

The second layer is realized using:
Second etching solution: HF 21%, H₂O 21%, EtOH 58%
Current: 800 mA/ cm²
Etching time: 0.5s
room temperature (P)

The removal of the double layer has been performed by immersing the samples in a NaOH 1M solution for 4 minutes and then rinsing in deionized water 1 minute.

The third layer 110 is formed as follows:
etching solution: HF 21%, H₂O 21%, EtOH 58%
Current: 800 mA/ cm²
Etching time: 1.5s
room temperature (P)

The resulting pores density in the third layer 110 is 11.6 pores/µm (134 pores/µm²) and this is the SEM picture of figures 3a and 4a.
Sample 2 of figures 3b and 4b

The first layer is realized using:
First etching Solution: HF 25%, H₂O 25%, EtOH 50%
Current: 750 mA/cm²
Etching time:1s
room temperature (P)
Princeton Applied Research potentiostat model PARSTAT 2270

The second layer is realized using:
Second etching solution: HF 21%, H₂O 21%, EtOH 58%
Current: 800 mA/ cm²
Etching time: 0.5s
room temperature (P)
Princeton Applied Research potentiostat model PARSTAT 2270

The removal of the double layer has been performed by immersing the samples in a NaOH 1M solution for 4 minutes and then rinsing in deionized water 1 minute. After the double layer has been etched, the sample is porosified again on the patterned surface forming the third layer 110.

The third layer 110 is formed as follows:
etching solution: HF 21%, H₂O 21%, EtOH 58%
Current: 800 mA/ cm²
Etching time: 1.5s
room temperature (P)
Princeton Applied Research potentiostat model PARSTAT 2270

The resulting pores density in the third layer 110 is 10,45 pores/µm (109 pores/µm²) and this is the SEM picture of figures 3b and 4b.
Sample 3 of figures 3c and 4c

The first layer is realized using:
First etching Solution: HF 25%, H₂O 25%, EtOH 50%
Current: 900 mA/cm²
Etching time:1s
room temperature (P)
Princeton Applied Research potentiostat model PARSTAT 2270

The second layer is realized using:
Second etching solution: HF 21%, H₂O 21%, EtOH 58%
Current: 800 mA/ cm²
Etching time: 0.5s
room temperature (P)
Princeton Applied Research potentiostat model PARSTAT 2270

The removal of the double layer has been performed by immersing the samples in a NaOH 1M solution for 4 minutes and then rinsing in deionized water 1 minute. After the double layer has been etched, the sample is porosified again on the patterned surface forming the third layer 110.

The third layer 110 is formed as follows:
etching solution: HF 21%, H₂O 21%, EtOH 58%
Current: 800 mA/ cm²
Etching time: 1.5s
room temperature (P)
Princeton Applied Research potentiostat model PARSTAT 2270

The resulting pores density in the third layer 110 is 11.4 pores/µm (130 pores/µm²) and this is the SEM picture of figures 3c and 4c.

The SEM images of the three samples of figures 3a-3c and figures 4a-4c show that the effect of increasing the current density in the first layer for a given set of other parameters is that of reducing the overall number of pores in the third layer (and in the first layer as well).

### Example 2

This example shows the effect of the second porous layer on the remaining substrate when the first and second layer are removed or only when a single layer is removed.

The substrate is the same as in Example 1.

First three samples are fabricated, each of which includes a single first layer (no second layer is formed). The first layer is then removed and only the bottom part of it remains, that is, the end parts of the pores of the first layer still remain on the substrate. The differences between these three samples is the removal time, i.e. the time in which the etching solution acts on the substrate including the first layer to remove the latter. These samples are then compared with the effect on the surface of the substrate when a first and a second layer are formed and then removed.

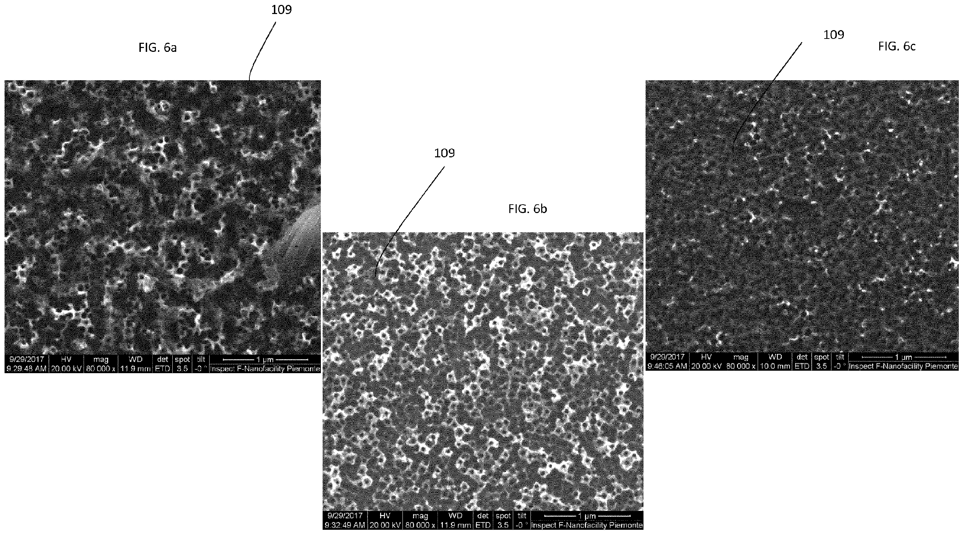

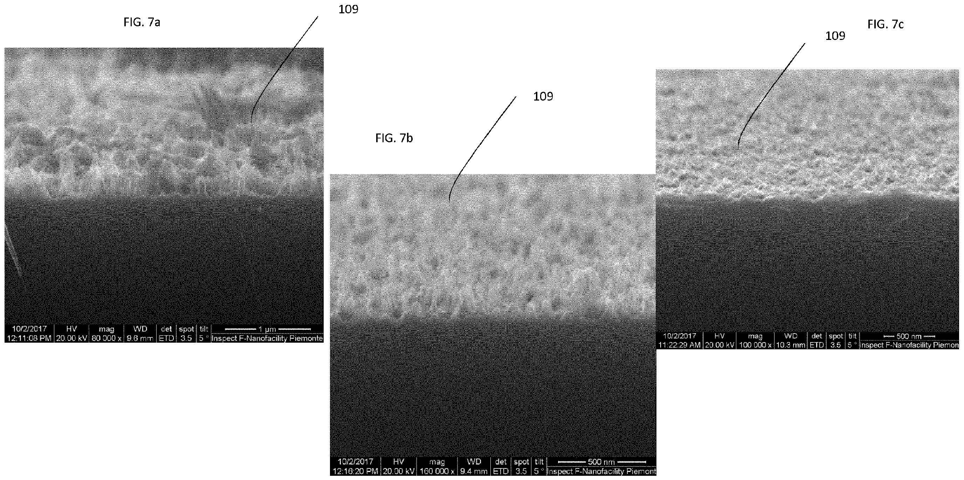

Sample 1 of figures 6a and 7a

The first layer is realized using:
First etching Solution: HF 25%, H₂O 25%, EtOH 50%
Current: 600 mA/cm²
Etching time: 1s
room temperature (P)
Princeton Applied Research potentiostat model PARSTAT 2270

The removal of the first layer has been performed by immersing the samples in a NaOH 1M solution for 50 seconds and then rinsing in deionized water 1 minute.

Sample 2 of figures 6b and 7b

The first layer is realized using:
First etching Solution: HF 25%, H₂O 25%, EtOH 50%
Current: 600 mA/cm²
Etching time: 1s
room temperature (P)
Princeton Applied Research potentiostat model PARSTAT 2270

The removal of the first layer has been performed by immersing the samples in a NaOH 1M solution for 4 minutes and then rinsing in deionized water 1 minute.
Sample 3 of figures 6c and 7c

The first layer is realized using:
First etching Solution: HF 25%, H₂O 25%, EtOH 50%
Current: 600 mA/cm²
Etching time: 1s
room temperature (P)
Princeton Applied Research potentiostat model PARSTAT 2270

The removal of the first layer has been performed by immersing the samples in a NaOH 1M solution for 8 minutes and then rinsing in deionized water 1 minute.

Indeed, the more the etching time the less of the first layer is present.

The distribution of the "end portions" of the pores visible in the SEM pictures 6a-6c and 7a-7c is to be compared with the distribution of the pores which can be obtained removing a double layer according to the invention.

### Example 3

In this example, 3 samples are prepared where a third layer 110 is formed after the removal of a first and second layer realized according to the invention.

It is shown that the number of pores in the third layer is independent from the electrochemical conditions of the etching of the same and is controlled by the pores density on the first layer 101. The three samples have the same first layer and three different second layer. The images are obtained from samples where the first and second layers have been removed and a new pores formation process has been performed on the patterned surface.

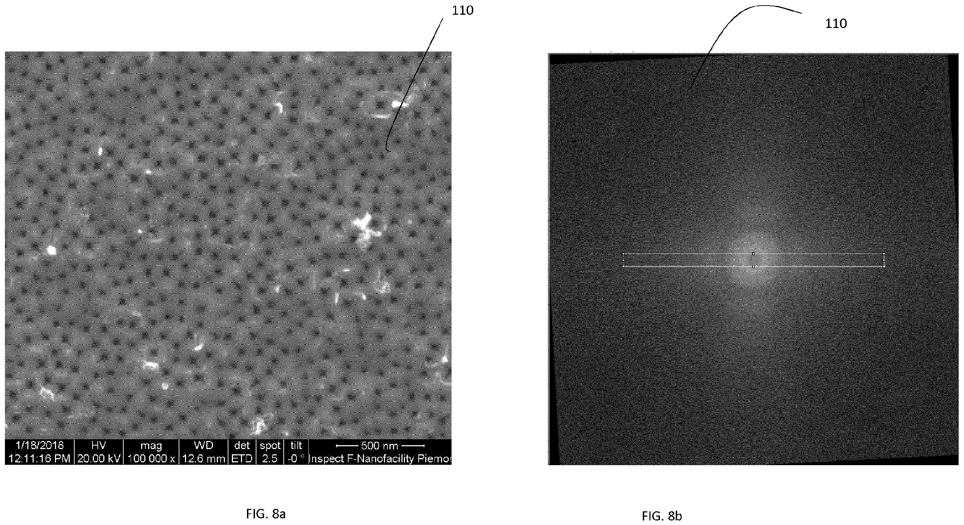

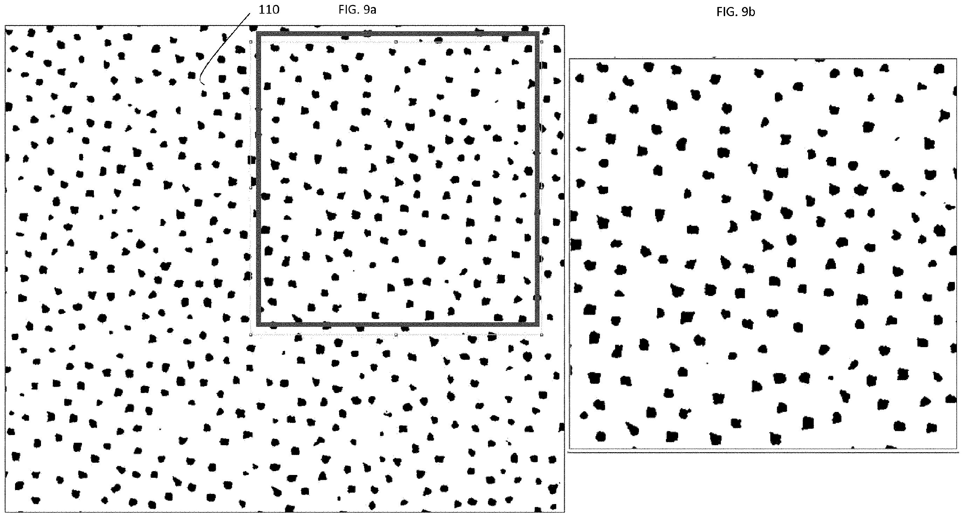

### Sample 1 of figures 8a-8b and 9a-9b

The first layer is realized using:
First etching Solution: HF 25%, H₂O 25%, EtOH 50%
Current: 600 mA/cm²
Etching time: 1s
room temperature (P)
Princeton Applied Research potentiostat model PARSTAT 2270

The second layer is realized using:
Second etching solution: HF 21%, H₂O 21%, EtOH 58%
Current: 800 mA/ cm²
Etching time: 0.5s
room temperature (P)
Princeton Applied Research potentiostat model PARSTAT 2270

The removal of the double layer has been performed by immersing the samples in a NaOH 1M solution for 4 minutes and then rinsing in deionized water 1 minute. After the double layer has been etched, the sample is porosified again on the patterned surface forming the third layer 110.

The third layer is then formed using
A third etching solution: HF 21%, H₂O 21%, EtOH 58%
Current: 800 mA/cm²
Etching time: 1.5s
room temperature (P)
Princeton Applied Research potentiostat model PARSTAT 2270

A SEM picture of a top view with the pores distribution is shown in figure 8a. An analysis whether a correlation is present among the spatial distribution of the pores is performed using a Fast Fourier Transform technique. Figure 9a is a representation of the pores distribution and figure 9b represents an enlarged view of the area surrounded by a rectangle in figure 9a. The area of figure 9b represents the analyzed area. It is the same size for all three samples and is the maximum size that allows to analyze a sufficiently homogeneous area of the sample.

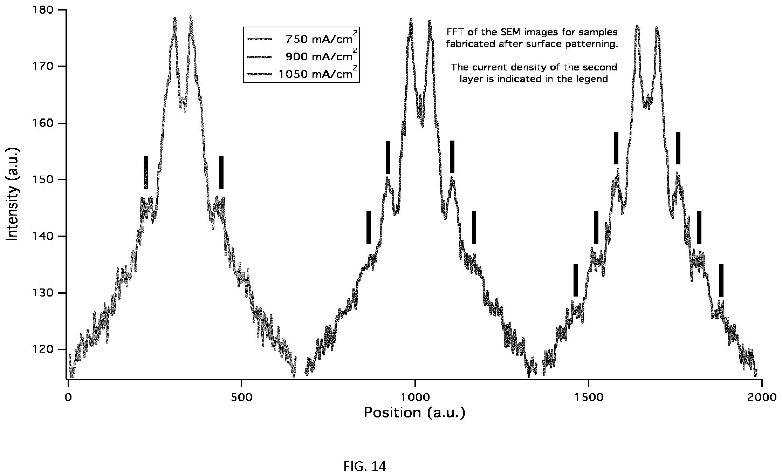

As shown in figure 8b a FFT image is taken. The FFT image has been slightly rotated so that the branches become horizontal and allow for a correct image analysis. The rectangle indicates the area whose intensity distribution has been plotted. The results of the analysis are shown in figure 14 as the left most curve.

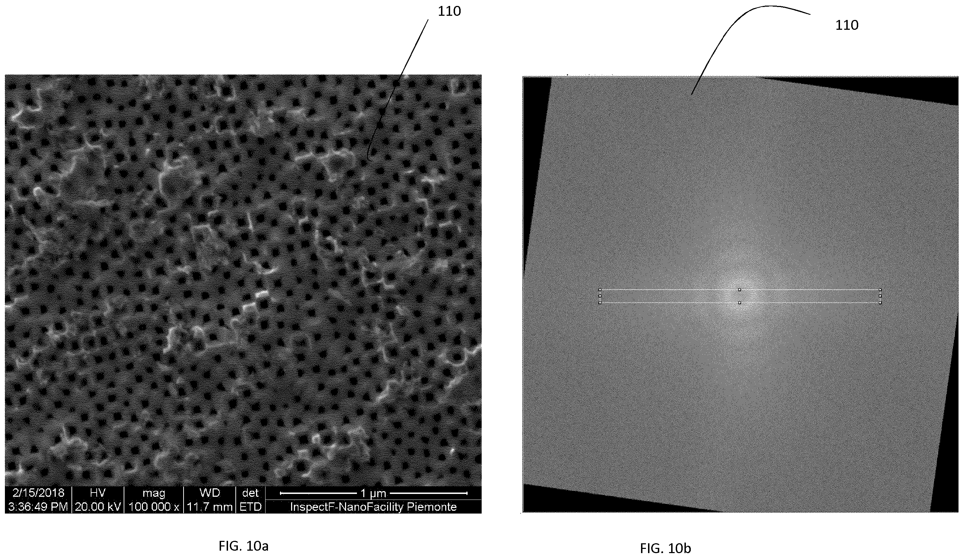

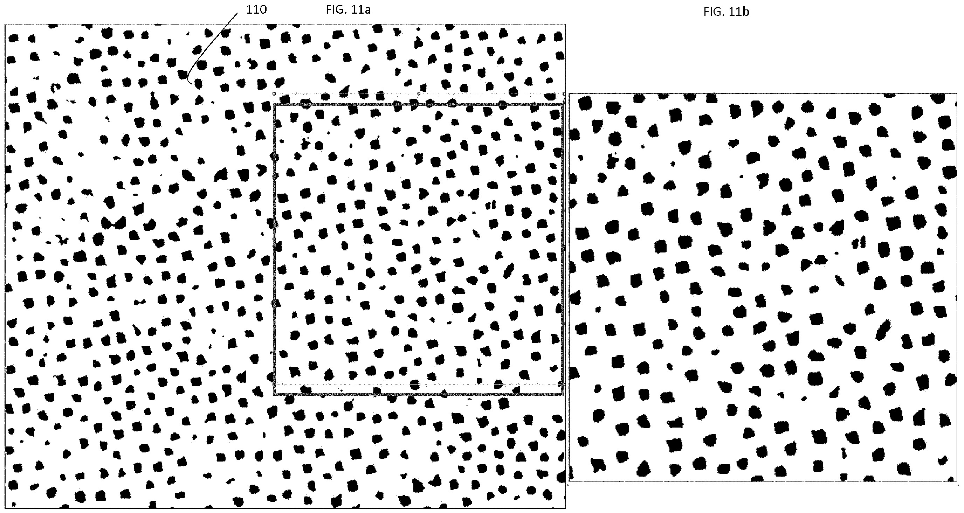

Sample 2 of figures 10a-10b and 11a-11b
The first layer is realized using:
First etching Solution: HF 25%, H₂O 25%, EtOH 50%
Current: 600 mA/cm²
Etching time: 1s
room temperature (P)
Keithley SMU 2450 SourceMeter ® SMU power source

The second layer is realized using:
Second etching solution: HF 21%, H₂O 21%, EtOH 58%
Current: 900 mA/ cm²
Etching time: 0.5s
room temperature (P)
Keithley SMU 2450 SourceMeter ® SMU power source

The removal of the double layer has been performed by immersing the samples in a NaOH 1M solution for 4 minutes and then rinsing in deionized water 1 minute. After the double layer has been etched, the sample is porosified again on the patterned surface forming the third layer 110.

The third layer is then formed using
A third etching solution: HF 21%, H₂O 21%, EtOH 58%
Current: 900 mA/cm²
Etching time: 1.5s
room temperature (P)
Keithley SMU 2450 SourceMeter ® SMU power source

A SEM picture of a top view with the pores distribution is shown in figure 10a. An analysis whether a correlation is present among the spatial distribution of the pores is performed using a Fast Fourier Transform technique. Figure 11a is a representation of the pores distribution and figure 11b represents an enlarged view of the area surrounded by a rectangle in figure 11a. The area of figure 11b represents the analyzed area. It is the same size for all three samples and is the maximum size that allows to analyze a sufficiently homogeneous area of the sample.

As shown in figure 11b a FFT image is taken. The FFT image has been slightly rotated so that the branches become horizontal and allow for a correct image analysis. The results of the analysis are shown in figure 14 as the middle curve.

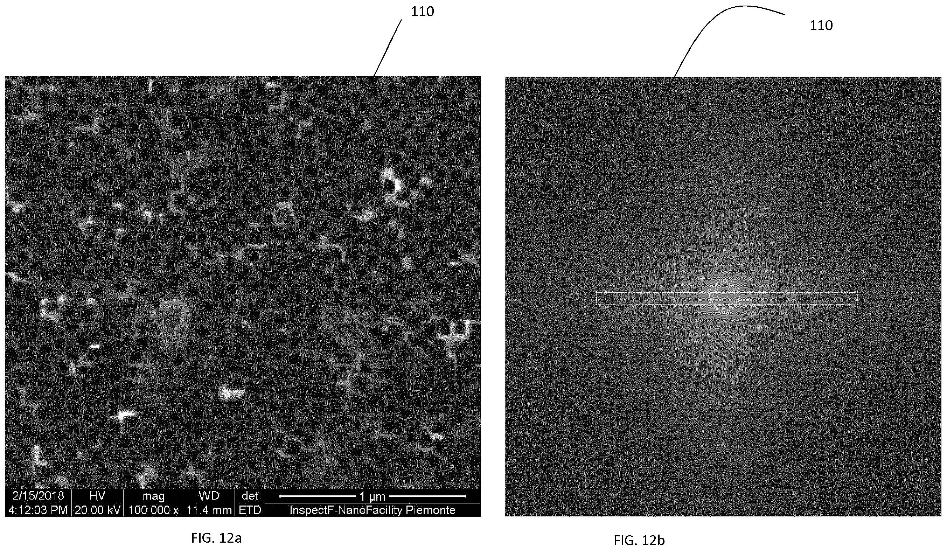

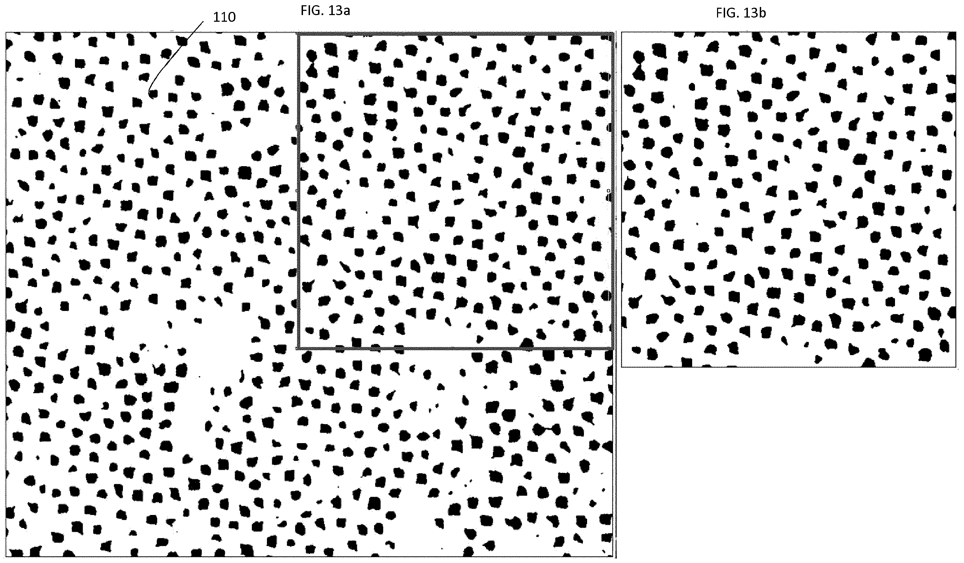

Sample 3 of figures 12a-12b and 13a-13b

The first layer is realized using:
First etching Solution: HF 25%, H₂O 25%, EtOH 50%
Current: 600 mA/cm²
Etching time: 1s
room temperature (P)
Keithley SMU 2450 SourceMeter ® SMU power source

The second layer is realized using:
Second etching solution: HF 21%, H₂O 21%, EtOH 58%
Current: 1050 mA/ cm²
Etching time: 0.5s
Keithley SMU 2450 SourceMeter ® SMU power source room temperature (P)

The removal of the double layer has been performed by immersing the samples in a NaOH 1M solution for 4 minutes and then rinsing in deionized water 1 minute. After the double layer has been etched, the sample is porosified again on the patterned surface forming the third layer 110.

The third layer is then formed using
A third etching solution: HF 21%, H₂O 21%, EtOH 58%
Current: 900 mA/cm²
Etching time: 1.5s
room temperature (P)
Keithley SMU 2450 SourceMeter ® SMU power source

A SEM picture of a top view with the pores distribution is shown in figure 12a. An analysis whether a correlation is present among the spatial distribution of the pores is performed using a Fast Fourier Transform technique. Figure 13a is a representation of the pores distribution and figure 13b represents an enlarged view of the area surrounded by a rectangle in figure 13a. The area of figure 13b represents the analyzed area. It is the same size for all three samples and is the maximum size that allows to analyze a sufficiently homogeneous area of the sample.

As shown in figure 12b a FFT image is taken. The FFT image has been slightly rotated so that the branches become horizontal and allow for a correct image analysis. The results of the analysis are shown in figure 14 as the right most curve.

Figure 14 shows the results of the FFT analysis. The presence of a long-range order is visible from the persistence of the oscillations in the FFT. In this example series of samples, the presence of additional peaks is evidenced as the current density of the second layer is increased showing the increase of the long-range correlation. The increase of long-range correlation, without being bound by theory, is due most probably because a higher current density forms pores which are wider and less dendritic, thus the electric field becomes more homogeneous which in turn causes a more homogeneous distributions of the pores in the second porous layer. A more homogeneous distributions of the pores in the second layer results, when the first and second layer are removed at least partially, in a more homogeneous distribution of the "seeds" on the new surface of the substrate. The homogenous seeds lead then to a homogeneous distribution of pores in the third porous layer.

### Example 4

In figures 16a - 16b the structures schematically depicted in figure 1a and 2a are shown for different parameters of the electrochemical process.

The sample in Figure 16a has been fabricated as follows:
The first layer is realized using:
   First etching Solution: HF 25%, H₂O 25%, EtOH 50%
   Current: 600 mA/cm²
   Etching time: 1s
   room temperature (P)
   Princeton Applied Research potentiostat model PARSTAT 2270
The second layer is realized using:
   Second etching solution: HF 21%, H₂O 21%, EtOH 58%
   Current: 800 mA/ cm²
   Etching time: 0.5s
   Princeton Applied Research potentiostat model PARSTAT 2270

The sample in Figure 16b has been fabricated as follows:
The first layer is realized using:
   First etching Solution: HF 25%, H₂O 25%, EtOH 50%
   Current: 900 mA/cm²
   Etching time: 1s
   room temperature (P)
   Princeton Applied Research potentiostat model PARSTAT 2270
The second layer is realized using:
   Second etching solution: HF 21%, H₂O 21%, EtOH 58%
   Current: 800 mA/ cm²
   Etching time: 0.5s
   Princeton Applied Research potentiostat model PARSTAT 2270

## Claims

1. A method for the fabrication of a porous layer with controlled pores distribution in a semiconductor substrate having a free surface by anodic etching, including the steps of:
- selecting a desired density of pores;
- selecting:
∘ a relative concentration of one or more components of a first etching solution, said components comprising an acid and possibly a surfactant and/or an oxidizing agent, and/or
∘ a parameter of a first current, and/or
∘ an intensity of an electromagnetic radiation impinging on a free surface (103) of the semiconductor substrate,
on the basis of said desired density of pores;
- contacting the free surface (103) of the semiconductor substrate (100) with the first chemical etching solution, and, during the contact, applying the first current so as to form a first porous layer (101) having substantially the desired density of pores (106);
- changing:
∘ the parameter of the first current, obtaining a second current, and/or
∘ the relative concentration of one or more components of the first etching solution, obtaining a second etching solution, and/or
∘ the intensity of the electromagnetic radiation impinging on the free surface of the semiconductor substrate,
so as to continue to etch the semiconductor substrate (100) and form a second porous layer (105) underneath the first porous layer (101), in such a way that the second porous layer has pores (107) having a mean pore dimension larger than a mean pore dimension of the pores (106) of the first porous layer;
- selecting a region of the semiconductor where the first and second porous layer (101, 105) are present;
- in that selected region removing:
∘ the first porous layer (101) completely, and
∘ the second porous layer (105) partially, to obtain a new free surface (109) of the semiconductor substrate on which indentations (108) are formed having a controlled distribution;
- anodically etching the new free surface (109) to form a third porous layer (110) having a pores distribution function of the distribution of the indentations.

2. Method according to claim 1, wherein said semiconductor substrate (100) is a silicon substrate and said first and/or second and/or third porous layers (101, 105, 110) are a first, second and/or third porous silicon layers.

3. Method according to claim 1 or 2, wherein said semiconductor substrate (100) is either p-doped or n-doped.

4. Method according to any of the preceding claims, wherein the etching of the third layer (110) includes:
∘ contacting the new free surface (109) of the semiconductor substrate with a third chemical etching solution, and, during the contact, applying a third current so as to form the third porous layer.

5. Method according to any of the preceding claims, wherein said acid in the first etching solution and/or in the second etching solution and/or in the third etching solution is one of: Hydrofluoric acid, hydrochloric acid, nitric acid.

6. Method according to any of the preceding claims, wherein the first etching solution and/or the second etching solution and/or the third etching solution includes one or more of: water, hydrofluoric acid, a surfactant, an oxidizing agent.

7. Method according to any of the preceding claims, wherein the first and the second porous layer (101, 105) have a first and a second thickness, respectively, and wherein the step of removing the first porous layer completely and the second layer partially includes removing a portion of the first porous layer through all its first thickness and removing a portion of the second layer for a depth smaller than the second thickness so that a remaining part (109) of the second porous layer is left on the semiconductor substrate (100).

8. Method according to claim 7, wherein a thickness of the remaining part (109) of the second porous layer is of at least ½ of the mean dimension of the pores (107) of the second porous layer (105).

9. Method according to any of the preceding claims, wherein the formation of the first and/or second and/or third porous layer (101, 105, 110) takes place in an electrochemical cell (200).

10. Method according to any of the preceding claims, wherein the mean pores dimension in the second porous layer (105) is comprised between 15 nm and 200 nm.

11. Method according to any of the preceding claims, wherein the mean pores dimension in the first porous layer (101) is comprised between 10 nm and 150 nm.

12. Method according to any of the preceding claims, wherein a first thickness of the first porous layer (101) is comprised between 100 nm and 30 µm.

13. Method according to any of the preceding claims, wherein a second thickness of the second porous layer (105) is comprised between 100 nm and 30 µm.

14. Method according to any of the preceding claims, wherein the step of changing:
∘ the parameter of the first current, obtaining a second current, and/or
∘ the relative concentration of one or more components of the first etching solution, creating a second etching solution, and/or
∘ the intensity of the electromagnetic radiation impinging on a free surface of the semiconductor substrate,
includes:
∘ increasing the applied current, and/or
∘ decrease the acid concentration present in the first etching solution, and/or
∘ adding to the first etching solution an oxidizing agent.

15. Method according to one or more of the preceding claims, wherein the step of removing the first layer (101) completely and the second porous layer (105) partially includes etching the first and second layer.

## Patentansprüche

1. Verfahren zur Herstellung einer porösen Schicht mit kontrollierter Porenverteilung in einem Halbleitersubstrat mit einer freien Oberfläche durch anodisches Ätzen, das folgende Schritte umfasst:
- Auswählen einer gewünschten Porendichte;
- Auswählen:
∘ einer relativen Konzentration einer oder mehrerer Komponenten einer ersten Ätzlösung, wobei die Komponenten eine Säure und möglicherweise ein Tensid und/oder ein Oxidationsmittel umfassen, und/oder
∘ eines Parameters eines ersten Stroms, und/oder
∘ einer Intensität einer elektromagnetischen Strahlung, die auf eine freie Oberfläche (103) des Halbleitersubstrats auftrifft,
basierend auf der gewünschten Porendichte;
- Kontaktieren der freien Oberfläche (103) des Halbleitersubstrats (100) mit der ersten chemischen Ätzlösung und, während des Kontakts, Anlegen des ersten Stroms zum Bilden einer ersten porösen Schicht (101) mit der im Wesentlichen gewünschten Porendichte (106);
- Verändern:
∘ des Parameters des ersten Stroms, wobei ein zweiter Strom erhalten wird, und/oder
∘ der relativen Konzentration einer oder mehrerer Komponenten der ersten Ätzlösung, wobei eine zweite Ätzlösung erhalten wird, und/oder
∘ der Intensität der elektromagnetischen Strahlung, die auf die freie Oberfläche des Halbleitersubstrats auftrifft,
um das Ätzen des Halbleitersubstrats (100) fortzusetzen und eine zweite poröse Schicht (105) unter der ersten porösen Schicht (101) derart zu bilden, dass die zweite poröse Schicht Poren (107) mit einer mittleren Porengröße aufweist, die größer als eine mittlere Porengröße der Poren (106) der ersten porösen Schicht ist;
- Auswählen einer Region des Halbleiters, in dem die erste und zweite poröse Schicht (101, 105) vorhanden ist;
- in dieser ausgewählten Region, Entfernen:
∘ der ersten porösen Schicht (101) vollständig, und
∘ der zweiten porösen Schicht (105) teilweise, um eine neue freie Oberfläche (109) des Halbleitersubstrats zu erhalten, auf der Vertiefungen (108) mit kontrollierter Verteilung ausgebildet sind;
- anodisches Ätzen der neuen freien Oberfläche (109) zum Bilden einer dritten porösen Schicht (110) mit einer Porenverteilungsfunktion der Verteilung der Vertiefungen.

2. Verfahren nach Anspruch 1, wobei das Halbleitersubstrat (100) ein Siliziumsubstrat ist, und die ersten und/oder zweiten und/oder dritten porösen Schichten (101, 105, 110) eine erste, zweite und/oder dritte poröse Siliziumschicht sind.

3. Verfahren nach Anspruch 1 oder 2, wobei das Halbleitersubstrat (100) entweder p-dotiert oder n-dotiert ist.

4. Verfahren nach einem der vorstehenden Ansprüche, wobei das Ätzen der dritten Schicht (110) umfasst:
∘ Kontaktieren der neuen freien Oberfläche (109) des Halbleitersubstrats mit einer dritten chemischen Ätzlösung, und, während des Kontakts, Anlegen eines dritten Stroms, zum Bilden der dritten porösen Schicht.

5. Verfahren nach einem der vorstehenden Ansprüche, wobei die Säure in der ersten Ätzlösung und/oder in der zweiten Ätzlösung und/oder in der dritten Ätzlösung eine der folgenden ist: Fluorwasserstoffsäure, Salzsäure, Salpetersäure.

6. Verfahren nach einem der vorhergehenden Ansprüche, wobei die erste Ätzlösung und/oder die zweite Ätzlösung und/oder die dritte Ätzlösung eine oder mehrere der folgenden umfasst: Wasser, Fluorwasserstoffsäure, ein Tensid, ein Oxidationsmittel.

7. Verfahren nach einem der vorhergehenden Ansprüche, wobei die erste und die zweite poröse Schicht (101, 105) jeweils eine erste und eine zweite Dicke aufweisen, und wobei der Schritt des vollständigen Entfernens der ersten porösen Schicht und des teilweisen Entfernens der zweiten Schicht das Entfernen eines Bereichs der ersten porösen Schicht durch deren gesamte erste Dicke, und das Entfernen eines Bereichs der zweiten Schicht über eine Tiefe umfasst, die kleiner als die zweite Dicke ist, sodass ein verbleibender Teil (109) der zweiten porösen Schicht auf dem Halbleitersubstrat (100) übrig bleibt.

8. Verfahren nach Anspruch 7, wobei eine Dicke des verbleibenden Teils (109) der zweiten porösen Schicht zumindest die Hälfte der mittleren Größe der Poren (107) der zweiten porösen Schicht (105) beträgt.

9. Verfahren nach einem der vorhergehenden Ansprüche, wobei das Bilden der ersten und/oder zweiten und/oder dritten porösen Schicht (101, 105, 110) in einer elektrochemischen Zelle (200) stattfindet.

10. Verfahren nach einem der vorhergehenden Ansprüche, wobei die mittlere Porengröße in der zweiten porösen Schicht (105) zwischen 15 nm und 200 nm liegt.

11. Verfahren nach einem der vorstehenden Ansprüche, wobei die mittlere Porengröße in der ersten porösen Schicht (101) zwischen 10 nm und 150 nm liegt.

12. Verfahren nach einem der vorhergehenden Ansprüche, wobei die erste Dicke der ersten porösen Schicht (101) zwischen 100 nm und 30 µm liegt.

13. Verfahren nach einem der vorhergehenden Ansprüche, wobei eine zweite Dicke der zweiten porösen Schicht (105) zwischen 100 nm und 30 µm liegt.

14. Verfahren nach einem der vorhergehenden Ansprüche, wobei der Schritt des Veränderns:
∘ des Parameters des ersten Stroms, wobei ein zweiter Strom erhalten wird, und/oder
∘ der relativen Konzentration einer oder mehrerer Komponenten der ersten Ätzlösung, wobei eine zweite Ätzlösung erstellt wird, und/oder
∘ der Intensität der elektromagnetischen Strahlung, die auf eine freie Oberfläche des Halbleitersubstrats auftrifft,
folgendes umfasst:
∘ Erhöhen des angelegten Stroms, und/oder
∘ Reduzieren der in der ersten Ätzlösung vorhandenen Säurekonzentration, und/oder
∘ Zugeben eines Oxidationsmittels zur ersten Ätzlösung.

15. Verfahren nach einem oder mehreren der vorhergehenden Ansprüche, wobei der Schritt des Entfernens der ersten Schicht (101) vollständig und der zweiten porösen Schicht (105) teilweise das Ätzen der ersten und zweiten Schicht umfasst.

## Revendications

1. Procédé de fabrication d'une couche poreuse à répartition des pores régulée dans un substrat semi-conducteur ayant une surface libre par gravure anodique, comportant les étapes :
- de sélection d'une densité souhaitée de pores ;
- de sélection :
∘ d'une concentration relative d'un ou plusieurs composants d'une première solution de gravure, lesdits composants comprenant un acide et éventuellement un surfactant et/ou un agent oxydant, et/ou
∘ d'un paramètre d'un premier courant, et/ou
∘ d'une intensité d'un rayonnement électromagnétique frappant une surface libre (103) du substrat semi-conducteur,
sur la base de ladite densité souhaitée de pores ;
- de mise en contact de la surface libre (103) du substrat semi-conducteur (100) avec la première solution de gravure chimique, et, pendant le contact, d'application du premier courant de manière à former une première couche poreuse (101) ayant sensiblement la densité de pores souhaitée (106) ;
- de modification :
∘ du paramètre du premier courant, obtenant un deuxième courant, et/ou
∘ de la concentration relative d'un ou plusieurs composants de la première solution de gravure, obtenant une deuxième solution de gravure, et/ou
∘ de l'intensité du rayonnement électromagnétique frappant la surface libre du substrat semi-conducteur,
de manière à continuer à graver le substrat semi-conducteur (100) et à former une deuxième couche poreuse (105) sous la première couche poreuse (101), de telle sorte que la deuxième couche poreuse ait des pores (107) ayant une dimension de pores moyenne supérieure à une dimension de pores moyenne des pores (106) de la première couche poreuse ;
- de sélection d'une région du semi-conducteur où la première et la deuxième couche poreuse (101, 105) sont présentes ;
- dans cette région sélectionnée :
∘ d'élimination complète de la première couche poreuse (101), et
∘ d'élimination partielle de la deuxième couche poreuse (105), pour obtenir une nouvelle surface libre (109) du substrat semi-conducteur sur laquelle sont formées des indentations (108) ayant une répartition régulée ;
- de gravure anodique de la nouvelle surface libre (109) pour former une troisième couche poreuse (110) ayant une fonction de répartition des pores de la répartition des indentations.

2. Procédé selon la revendication 1, dans lequel ledit substrat semi-conducteur (100) est un substrat de silicium et lesdites premières et/ou deuxièmes et/ou troisièmes couches poreuses (101, 105, 110) sont des premières, deuxièmes et/ou troisièmes couches de silicium poreuses.

3. Procédé selon la revendication 1 ou 2, dans lequel ledit substrat semi-conducteur (100) est soit dopé p, soit dopé n.

4. Procédé selon l'une quelconque des revendications précédentes, dans lequel la gravure de la troisième couche (110) comporte :
∘ la mise en contact de la nouvelle surface libre (109) du substrat semi-conducteur avec une troisième solution de gravure chimique, et, pendant le contact, l'application d'un troisième courant de manière à former la troisième couche poreuse.

5. Procédé selon l'une quelconque des revendications précédentes, dans lequel ledit acide dans la première solution de gravure et/ou dans la deuxième solution de gravure et/ou dans la troisième solution de gravure est l'un parmi : l'acide fluorhydrique, l'acide chlorhydrique, l'acide nitrique.

6. Procédé selon l'une quelconque des revendications précédentes, dans lequel la première solution de gravure et/ou la deuxième solution de gravure et/ou la troisième solution de gravure comporte un ou plusieurs parmi : l'eau, l'acide fluorhydrique, un surfactant, un agent oxydant.

7. Procédé selon l'une quelconque des revendications précédentes, dans lequel les premières et deuxièmes couches poreuses (101, 105) ont une première et une deuxième épaisseur, respectivement, et dans lequel l'étape d'élimination complète de la première couche poreuse et d'élimination partielle de la deuxième couche comporte l'élimination d'une portion de la première couche poreuse sur toute sa première épaisseur et l'élimination d'une portion de la deuxième couche pour une profondeur inférieure à la deuxième épaisseur de sorte qu'une partie restante (109) de la deuxième couche poreuse soit laissée sur le substrat semi-conducteur (100).

8. Procédé selon la revendication 7, dans lequel une épaisseur de la partie restante (109) de la deuxième couche poreuse fait au moins 1/2 de la dimension de pores moyenne (107) de la deuxième couche poreuse (105).

9. Procédé selon l'une quelconque des revendications précédentes, dans lequel la formation de la première et/ou de la deuxième et/ou de la troisième couche poreuse (101, 105, 110) a lieu dans une cellule électrochimique (200).

10. Procédé selon l'une quelconque des revendications précédentes, dans lequel la dimension de pores moyenne dans la deuxième couche poreuse (105) est comprise entre 15 nm et 200 nm.

11. Procédé selon l'une quelconque des revendications précédentes, dans lequel la dimension de pores moyenne dans la première couche poreuse (101) est comprise entre 10 nm et 150 nm.

12. Procédé selon l'une quelconque des revendications précédentes, dans lequel une première épaisseur de la première couche poreuse (101) est comprise entre 100 nm et 30 µm.

13. Procédé selon l'une quelconque des revendications précédentes, dans lequel une deuxième épaisseur de la deuxième couche poreuse (105) est comprise entre 100 nm et 30 µm.

14. Procédé selon l'une quelconque des revendications précédentes, dans lequel l'étape de modification :
∘ du paramètre du premier courant, obtenant un deuxième courant, et/ou
∘ de la concentration relative d'un ou plusieurs composants de la première solution de gravure, créant une deuxième solution de gravure, et/ou
∘ de l'intensité du rayonnement électromagnétique frappant une surface libre du substrat semi-conducteur,
comporte :
∘ l'augmentation du courant appliqué, et/ou
∘ la diminution de la concentration d'acide présente dans la première solution de gravure, et/ou
∘ l'ajout d'un agent oxydant à la première solution de gravure.

15. Procédé selon une ou plusieurs des revendications précédentes, dans lequel l'étape d'élimination complète de la première couche (101) et d'élimination partielle de la deuxième couche poreuse (105) comporte la gravure de la première et de la deuxième couche.
